# EUROPÄISCHE PATENTANMELDUNG

(11) **EP 0 706 214 A2**
(43) Veröffentlichungstag der Anmeldung: **10.04.1996**
(21) Anmeldenummer: 95118345.8
(22) Anmeldetag: 18.11.1993
(51) Int. Cl.: H01L 23/498, G06K 19/06

(54) **Elektronikmodul und Chipkarte**

(30) Priorität: 27.11.1992 CH 3633/92
(62) Teilanmeldung aus: 93118564.9
(71) Anmelder: ESEC SEMPAC S.A., CH-6330 Cham (CH)
(72) Erfinder: Nicklaus, Karl, CH-6330 Cham (CH)
(74) Vertreter: Hotz, Klaus, Dipl.-El.-Ing./ETH Patentanwalt

(57) **Zusammenfassung**

Trotz extremer Flachbauweise soll die Bruchneigung des im Kunststoffgehäuse (10) des Elektronikmoduls (M) eingebetteten Halbleiter-Chips (1) wesentlich vermindert werden. Der Chip ist auf der Chip-Insel (22) eines Systemträgers (20) in Form einer Blechstruktur (lead frame) montiert. Die Aussenkontakte (21) - die vom Chip teilweise überdeckt werden können - liegen in einer Ebene an der einen Flachseite des Modulgehäuses (10). Die die Chip-Insel (22) begrenzenden Schlitze (23), welche unvermeidbare Schwächungslinien im Blech des Systemträgers darstellen, verlaufen schiefwinklig (vorzugsweise unter 45°) zu den Kanten des quadratischen oder rechteckigen Chips (1), und damit auch schief zu den durch die Einkristall-Struktur im Chipmaterial gegebenen, wahrscheinlichen Bruchlinien, die parallel zu den Chip-Kanten verlaufen. Weitere, von den Schlitzen (23) ausgehende Schlitze (24) im Blech verlaufen zweckmässigerweise ebenfalls schief zu den Chip-Kanten. Weitere Massnahmen betreffen die mechanische Verbindung zwischen den Teilen des Systemträgers (20) und dem Modulgehäuse (10) sowie die Verbindung des ganzen Moduls (M) mit umgebender Kunststoffmasse beim Eingiessen in einen Trägerkörper (z.B. Chipkarten-Herstellung).

## Beschreibung

Die Erfindung betrifft ein Elektronikmodul nach dem Oberbegriff des Patentanspruchs 1 sowie eine Chip-Karte nach dem Oberbegriff des Patentanspruchs 4.

Ein Elektronikmodul dieser Art ist beispielsweise aus der US-A-5,134,773 bekannt geworden. Mit jenem Patent wurde ein Verfahren aufgezeigt, welches die Herstellung sogenannter Chip-Karten durch direktes Eingiessen des Moduls in das die Karte bildende Kunststoffmaterial ermöglicht, wobei die Aussenkontakte an der einen Seite der Karte freiliegen. Das betreffende Elektronikmodul bietet vor allem dadurch besondere Vorteile, dass dessen Aussenkontakte und Chip-Insel aus einem Systemträger in Form einer Blechstruktur (lead frame) bestehen; dies erlaubt eine rationelle, kostengünstige Produktion der Module nach bekannten Verfahren und mit Montageautomaten, wie sie bei der Halbleitermontage für integrierte Schaltungen allgemein üblich sind.

Elektronikmodule in extrem flacher Bauweise bieten allerdings besondere Probleme hinsichtlich Herstellung. Anders als bei den verbreiteten Bauformen, bei denen Systemträger und Halbleiter-Chip beidseitig mit Kunststoff umpresst, d.h. in einem Gehäuse ausreichender Dicke eingebettet sind (z.B. in einem sog. DIP-Gehäuse für Montage auf Leiterplatten), steht hier nur eine sehr begrenzte Bauhöhe für die Gesamtdicke des Elektronikmoduls zur Verfügung. Beispilesweise haben Chip-Karten eine Dicke von lediglich 0,8mm, und ähnliche Begrenzungen für die Modul-Dicke bestehen bei anderen Anwendungen von Flachgehäuse-Modulen, z.B. bei sog. elektronischen Schlüsseln oder dergleichen. Nicht nur muss das Modul in solchen Gegenständen wie z. B. Chip-Karten sehr dauerhaft verankert sein, damit die Chip-Karten genügend resistent sind, um bei den im Gebrauch vorkommenden erheblichen mechanischen und thermischen Beanspruchungen funktionstüchtig zu bleiben, sondern seine mit äusseren Elementen elektronisch zusammenwirkenden Teile, d.h. seine Aussenkontakte, müssen in der Chip-Karte und damit im Modulgehäuse selbst exakt an einer vorbestimmten Stelle angeordnet sein. Dies bedingt, dass die Module im Laufe ihrer Herstellung und Weiterverarbeitung z.B. ihrer Montage in Chip-Karten bei jedem Bearbeitungsschritt in einfacher Weise präzis angeordnet werden können. Es ist daher eine Aufgabe der Erfindung, ein Elektronikmodul vorzuschlagen, dessen Konfiguration eine genaue Positionierung der Aussenkontakte bei der Herstellung und Montage erlaubt, und zwar durch Mittel wie sie beim Einsatz üblicher Montageautomaten zur Verfügung stehen.

Diese Aufgabe wird erfindungsgemäss durch die Merkmale des kennzeichnenden Teils des Patentanspruchs 1 gelöst.

Die Fortsätze, welche aus Bereichen des Systemträgers bestehen, weisen Konturen, im allgemeinen Ausnehmungen auf, welche wie die Aussenkontakte selbst, ggfs sogar gleichzeitig, durch Ausstanzungen erzeugt und damit gegenüber den Aussenkontakten richtig hergestellt werden können und dadurch eine genaue Lagebeziehung zu den Aussenkontakten besitzen. Dieselben Fortsätze dienen sowohl zur Positionierung des Systemträgers mit einem darauf montierten Chip bei der Herstellung eines Zwischenproduktes, nämlich des Moduls, als auch zur Positionierung des Moduls bei dessen Weiterverwendung zur Herstellung eines Endproduktes wie z.B. einer Chip-Karte.

Besonders genau lässt sich der Systemträger im Modul bzw. das Modul in einer Chip-Karte oder dergl. positionieren, wenn zwei an entgegengesetzten Rändern des Kunststoffgehäuses des Moduls angeordnete Fortsätze vorgesehen sind.

Bevorzugt ist jeder Fortsatz ausserhalb des Kunststoffgehäuses abgekröpft, wobei die Höhe der Abkröpfung so gewählt wird, dass dass der Fortsatz mit seinem Ende in derjenigen Ebene liegt, in welcher sich die den Aussenkontakten gegenüberliegende Aussenfläche des Moduls befindet.

Eine weitere Aufgabe der Erfindung besteht darin, eine Chip-Karte der eingangs genannten Art vorzuschlagen, bei welchen die zur Verfügung stehende Bauhöhe durch ein präzis positionierbares Elektronikmodul der oben beschriebenen Art optimal ausgenützt wird.

Diese Aufgabe wird erfindungsgemäss durch die Merkmale des kennzeichnenden Teils des Patentanspruchs 4 gelöst.

Nachstehend werden Ausführungsbeispiele des Erfindungsgegenstandes in Verbindung mit der Zeichnung näher erläutert.
- Fig. 1: zeigt eine bevorzugte Ausführungsform eines Systemträgers,
- Fig. 2 und 3: zeigen, als Teildarstellung und ausgehend vom Systemträger nach Fig. 1, aufeinanderfolgende Herstellungsstufen eines beispielsweisen Elektronikmoduls,
- Fig. 4: veranschaulicht schematisch eine Spritzgiessform, in welcher ein Zwischenprodukt nach Fig. 2 zur Herstellung des Kunststoffgehäuses eingelegt ist (Schnitt entlang der Linie IV - IV in Fig. 2),
- Fig. 5: zeigt das fertige, vom Systemträger freigeschnittene und weiter verformte Modul im Schnitt entlang der Linie V - V in Fig. 3,
- Fig. 6: ist eine perspektivische Ansicht des Elektronikmoduls, und
- Fig. 7: zeigt in etwas grösserem Massstab und im Schnitt ein in einer weiteren Spritzgiessform eingelegtes und positioniertes Modul, in welcher Form das Modul zur Herstellung einer Chipkarte umgossen wird.

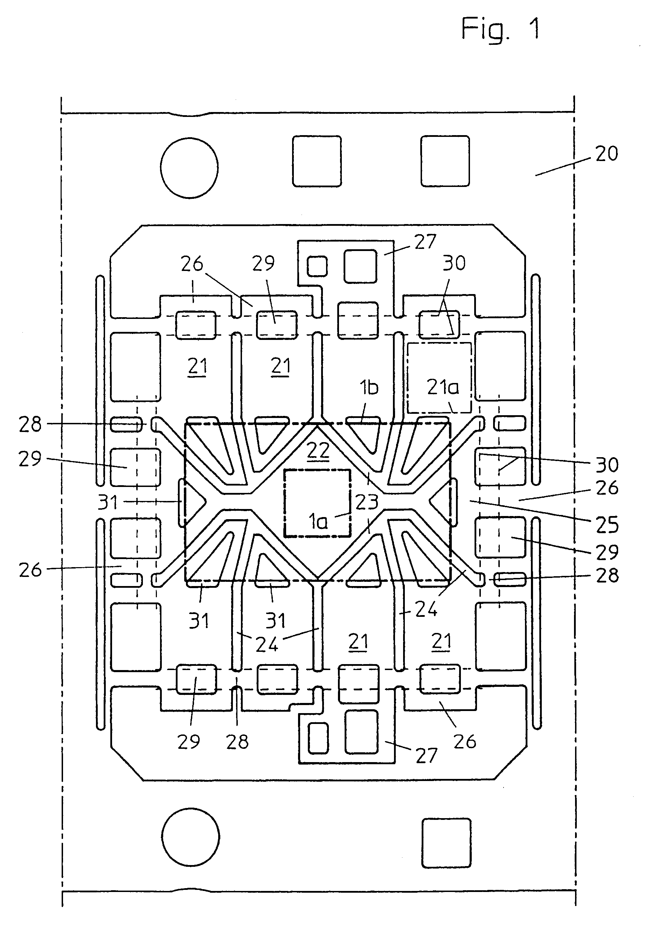

Es werden im folgenden zuerst die Einzelheiten des Systemträgers 20 anhand der Fig. 1 beschrieben, und anschliessend die Herstellung und der Aufbau des gesamten Elektronikmoduls. Fig. 1 zeigt stark vergrössert einen Abschnitt eines Systemträgers 20 in Form einer flachen, normalerweise gestanzten Blechstruktur (lead frame); wie mit strichpunktierten Linien angedeutet, schliessen seitlich weitere, gleichartige Abschnitte an, d.h. es wird in bekannter Weise ein längerer, gestanzter Blechstreifen mit eine Mehrzahl von Abschnitten nach Fig. 1 verwendet. Im Zentrum des Systemträgers 20 befindet sich eine vorzugsweise quadratische Chip-Insel 22, die durch Schlitze 23 begrenzt und beidseitig an Brücken 25 gehalten ist. Von den Schlitzen 23 gehen mehrere Schlitze 24 aus, die zusammen mit weiteren Ausstanzungen etwa rechteckige Bereiche 21 bilden. Diese Bereiche stellen am fertigen Elektronikmodul die Aussenkontakte dar. Beim vorliegenden Beispiel handelt es sich um ein Modul für Chipkarten, weshalb entsprechend der hierfür eingeführten Norm acht Aussenkontakte 21 - je vier in zwei parallelen Reihen - vorgesehen sind; zur Verdeutlichung ist in Fig. 1 am einen Aussenkontakt das eigentliche Kontaktfeld 21a strichpunktiert umrandet.

In Bereichen, die in der Umgebung der Chip-Insel 22 liegen, weisen die Kontakte 21 wie auch die beiden Brücken 25 Durchbrechungen 31 auf. Weiter ausserhalb sind in jedem Aussenkontakt 21 und in den beiden Brücken 25 fensterartige Durchbrechungen 29 vorgesehen. Etwa in Linie mit diesen Durchbrechungen sind die Kontakte 21 und die Brücken 25 untereinander durch Stege 28 verbunden, an denen die Schlitze 24 enden. An den Brücken 25 und den Kontakten 21 sind sodann über die Stege 28 hinausreichende Fortsätze 26, 27 angeformt. In der Fig. 1 sind schliesslich paarweise parallele, unterbrochene Linien 30 eingezeichnet, die im Bereich der Stege 28 und der "Fenster" 29 liegen und ein Rechteck umschreiben; hierbei handelt es sich um Biegelinien, entlang denen die Fortsätze 26 und 27 später abgekröpft werden. - Die Bedeutung der in diesem Abschnitt erwähnten Einzelheiten des Systemträgers 20 wird weiter unten im Zusammenhang mit der Herstellung des Moduls und dessen Einbau näher erläutert.

Die Chip-Insel 22 dient der Aufnahme eines Halbleiter-Chips, dessen integrierte Schaltung in bekannter Weise mit den Aussenkontakten 21 verbunden wird. In Fig. 1 sind zwei mögliche Lagen und Abmessungen solcher Chips strichpunktiert eingezeichnet: Mit 1a ist ein quadratischer Chip angedeutet, welcher vollständig auf der Chip-Insel 22 Platz findet. Es können jedoch wesentlich grössere Chips montiert werden, die beträchtlich über die Insel 22 hinausreichen und benachbarte Teile der Aussenkontakte 21 überdecken; es ist ein rechteckiges Format 1b eingetragen, welches bei der gegebenen Anordnung etwa den maximal möglichen Chip-Abmessungen entspricht. Von wesentlicher Bedeutung ist nun, dass die Schlitze 23, welche die Chip-Insel 22 begrenzen und diese von den Aussenkontakten 21 trennen, zu den Kanten des quadratischen oder rechteckigen Chips 1 schiefwinklig verlaufen, vorzugsweise, wie dargestellt, unter einem Winkel von etwa 45°. Zusätzlich von Vorteil ist es, wenn wenigstens ein Teil der die Aussenkontakte trennenden, von den Schlitzen 23 ausgehenden Schlitze 24 entlang geknickter Linien verlaufen, wodurch diese Schlitze wenigstens zum Teil ebenfalls zu den Chip-Kanten schiefwinklig stehen. In der Blechstruktur des Systemträgers 20 bilden die erwähnten Schlitze unvermeidliche Schwächungslinien. Anderseits ist es so, dass in der Struktur des (Silicium-)Einkristallmaterials, aus dem die Chips hergestellt sind, Brüche infolge Biegebeanspruchung praktisch immer parallel zu den Chip-Kanten auftreten. Durch die vorgenannten Massnahmen bzw. Montage-Orientierung wird erreicht, dass die Schwächungslinien der tragenden Blechstruktur nicht parallel zu den wahrscheinlichen Bruchlinien im Chip verlaufen, wodurch das Bruchrisiko für den Chip im mechanischen Verband des Moduls erheblich vermindert ist.

Beim vorliegenden Beispiel ist die Anordnung so getroffen, dass die Diagonalen der quadratischen Chip-Insel 22 zu den beiden Reihen der Aussenkontakte 21 parallel bzw. senkrecht stehen; die Chip-Insel könnte - bei gleicher Richtung der Diagonalen - etwa auch rhombusförmig gestaltet sein. Jedoch ist grundsätzlich (beispielsweise bei einer anderen Anordnung der Aussenkontakte) auch eine "umgekehrte" Anordnung denkbar, indem, bezogen auf die Hauptachsen des Systemträgers, eine quadratische oder rechteckige Chip-Insel "achsparallel", der Chip dagegen "schiefwinklig" angeordnet ist. Auch der Verlauf der die Kontakte trennenden Schlitze 24 kann variiert werden, wobei die angestrebte Wirkung in grösserem oder geringerem Ausmass durch die zum Chip schiefstehenden Abschnitte dieser Schlitze, vor allem in den vom Chip überdeckten Bereichen, erzielt wird.

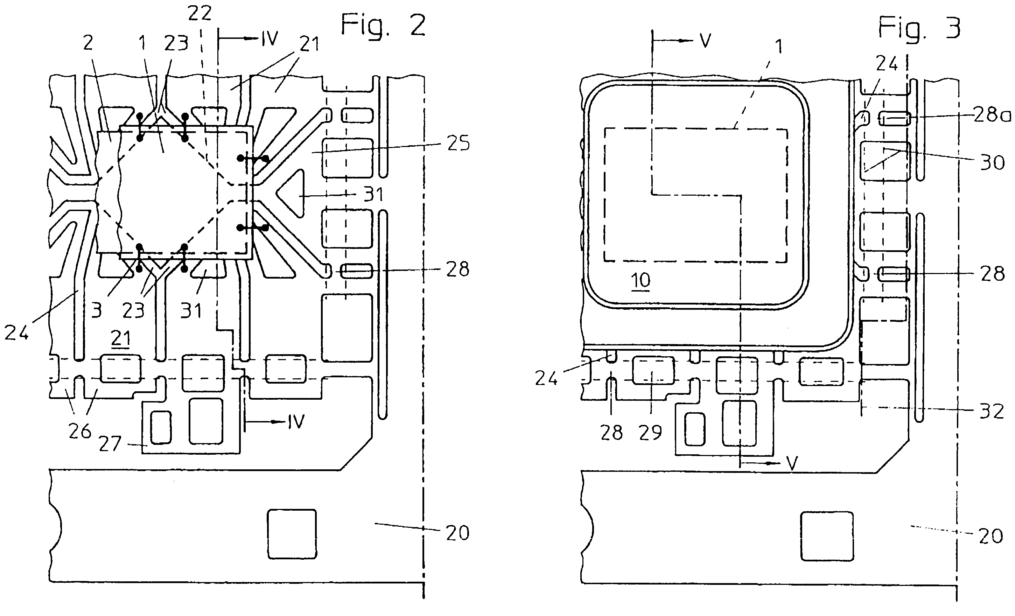

Anhand der Fig. 2, 3 und 4 werden nun wesentliche Herstellungsschritte des Elektronikmoduls, ausgehend vom Systemträger 20 nach Fig. 1, beschrieben. Gemäss Fig. 2 ist ein rechteckiger Halbleiter-Chip 1 auf der Insel 22 des Systemträgers montiert. Dieser Chip ist etwas kleiner als das maximal mögliche Format 1b nach Fig. 1, jedoch ragt der Chip 1 seitlich erheblich über die Chip-Insel hinaus und überdeckt benachbarte Teile der Aussenkontakte 21. Es sind bereits Drahtverbindungen 3 von der Halbleiterschaltung auf dem Chip zu den einzelnen Aussenkontakten 21 hergestellt. Für die Montage des Chips bzw. dessen mechanische Verbindung mit der Blechstruktur des Systemträgers 20 wird mit Vorteil eine doppelseitig beschichtete und isolierende Klebefolie 2 verwendet. Diese hat etwa das Format des Chips und besteht aus einem temperaturbeständigen Kunststoff (z.B. Polyamid oder Polyester) und einem Klebstoff, welcher nachher, bei der Herstellung des Kunststoffgehäuses durch Umpressen des Chips, polymerisiert. Eine solche Montagefolie 2 hat den Vorteil, erhebliche Unterschiede in der Wärmedehnung zwischen dem metallenen Systemträger und dem Material des Chips auszugleichen und ausserdem Schläge, die von aussen auf den Systemträger einwirken, gegenüber dem Chip zu dämpfen. Ausserdem wird durch die Folie 2 der Chip 1 gegenüber den Aussenkontakten 21 elektrisch isoliert. Montage und Kontaktierung des Chips 1 gemäss Fig. 2 erfolgen vollautomatisch auf leistungsfähigen Montageeinrichtungen, wie sie für die Halbleitermontage auf Systemträgern bewährt und verbreitet sind.

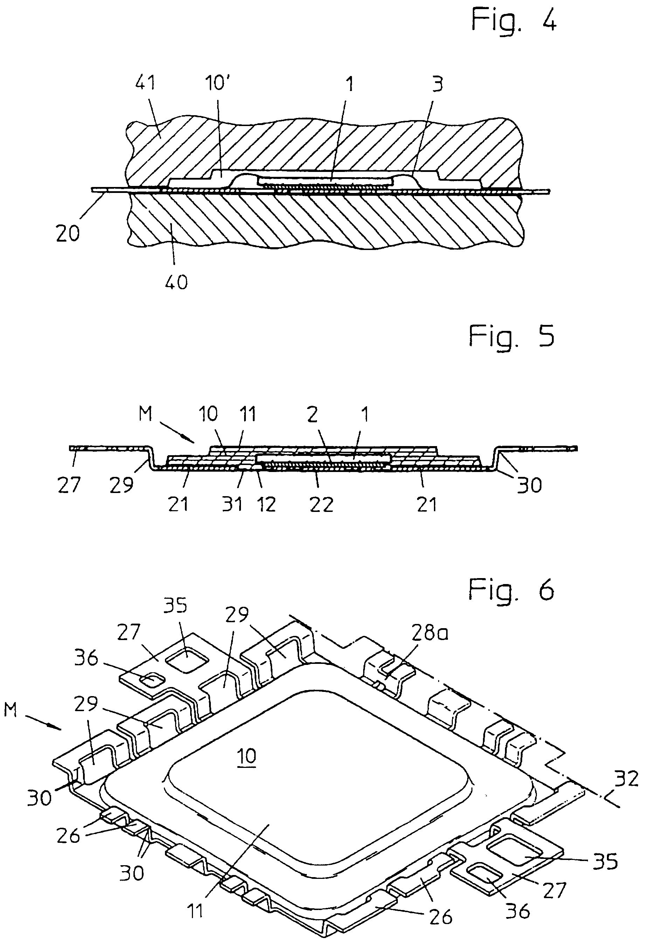

Sodann wird der bestückte Systemträger 20 zwecks Herstellung des flachen Kunststoffgehäuses in eine Pressform eingebracht, wie schematisch in Fig. 4 dargestellt ist; vorzugsweise handelt es sich um eine Mehrfachform, welche mehrere Moduleinheiten gleichzeitig aufnimmt. Auf der im wesentlichen ebenen, unteren Formhälfte 40 liegt der ebenfalls ebene Systemträger 20 ganzflächig auf, während die obere Formhälfte 41 den Formhohlraum 10' bildet. In diesem werden der Chip 1 und Teile des Systemträgers 20 mit der Kunststoffmasse umpresst und die Aussenkontur des Gehäuses 10 geformt.

Das ausgeformte Zwischenprodukt mit dem Gehäuse 10 ist in Fig. 3 dargestellt. Beim Pressvorgang sind sämtliche Schlitze 23 und 24 bis zu den Stegen 28 und ausserdem sämtliche Druchbrechungen 31 (Fig. 1) mit der Kunststoffmasse gefüllt worden. Diese schliesst mit der Aussenseite des Systemträgers 20 (auf der unteren Formhälfte 40 aufliegend, Fig. 4) überall bündig ab; dies gilt insbesondere auch im Querschnitt sämtlicher Durchbrechungen 31. Der Kunststoff des Gehäuses 10 bildet also zusammen mit der Aussenseite der Kontakte 21 des Systemträgers die eine, ebene Flachseite 12 des Elektronikmoduls (siehe Fig. 5).

Als Kunststoffmasse für das Gehäuse 10 wird ein Duroplast oder Kunstharz mit möglichst geringem Wärmeausdehnungskoeffizienten verwendet, wie sie zum Umpressen von Silicium-Chips bekannt sind (sogenannte "low stress"-Masse mit hohem Quarzanteil). Das Metall des Systemträgers 20 hat demgegenüber einen hohen Ausdehnungskoeffizient und dehnt sich in der Pressform bei der Temperatur des eingepressten des Kunststoffes entsprechend aus. Beim nachherigen Abkühlen des Metalls schrumpft dieses entsprechend und umschliesst bei den Durchbrechungen 31 den diese ausfüllenden, aushärtenden Kunststoff, wobei ein Pressitz hoher Festigkeit und Dichte entsteht. Dadurch wird eine mechanisch stabile Verankerung zwischen den Metallteilen und dem Kunststoff erreicht, ohne dass der letztere sich beim Giessvorgang ausserhalb der Blechteile ausbreiten muss und ohne dass eine Verformung oder Dickenbearbeitung des Metalls erforderlich wäre.

Es ist zweckmässig, das flache Kunststoffgehäuse 10 in der Dicke abzustufen, beispielsweise wie es aus den Figuren 4 bis 6 hervorgeht. Die volle Gehäusedicke ist nur in einem zentralen Bereich vorhanden, wo die Kunststoffmasse den Chip umschliesst und die den Aussenkontakten bzw. der Flachseite 12 gegenüberliegende Gehäuse-Flachseite 11 bildet. Dieser zentrale Bereich ist von einem Gehäuserand 13 mit geringerer Dicke umgeben; die Dickenverminderung kann dabei wie dargestellt in einer Stufe, oder in mehreren Stufen oder auch kontinuierlich erfolgen. Dadurch entsteht ein Querschnittsverlauf nach Art einer geschichteten Blattfeder (Fig. 5), was eine optimale Verteilung der Durchbiegung gewährleistet. Diese Massnahme trägt somit dazu bei, einen Teil der äusseren Belastung und Durchbiegung vom Chip 1 fernzuhalten.

Das nach dem Pressen des Kunststoffgehäuses 10 ausgeformte Zwischenprodukt nach Fig. 3 wird in folgender Weise weiterverarbeitet: Zunächst wird entlang von zwei symmetrischen Linien 32 (wovon nur eine in Fig. 3 sichtbar ist) das Modul aus dem Rahmen des Systemträgers 20 freigeschnitten. Gleichzeitig werden rings um das Gehäuse die Stege 28 ausgestanzt, mit Ausnahme eines Steges 28a (Fig. 3 und 6), welcher die Chip-Insel 22 über die eine Brücke 25 mit dem einen Aussenkontakt (oben rechts in Fig. 1) elektrisch verbindet, welcher den Masseanschluss für die Schaltung des Moduls bildet. In diesem Zustand kann das Elektronikmodul nun über seine Aussenkontakte elektrisch getestet werden. Sodann werden beim vorliegenden Beispiel, wo das Modul zum Eingiessen in einen flachen Kunststoff-Trägerkörper bestimmt ist (z.B. Chipkarte im Kreditkartenformat), die Blech-Fortsätze 26 und 27 rings um das Gehäuse 10 entlang den Biegelinien 30 abgekröpft, wie aus den Fig. 5 und 6 ersichtlich. Diese Abkröpfung erfolgt über die Dicke des Gehäuses 10 so, dass die Enden der genannten Fortsätze in die Ebene der den Aussenkontakten 21 gegenüberliegenden Gehäuse-Flachseite 11 zu liegen kommen. Die beiden Fortsätze 27, welche bezüglich des Gehäuses 10 einander gegenüberliegen, sowie ein Teil der Fortsätze 26 sind jeweils mit den Aussenkontakten 21 mechanisch verbunden, während weitere Fortsätze 26 von den beiden mit der Chip-Insel 22 verbundenen Brücken 25 ausgehen (Fig. 1). Die weiter oben im Zusammenhang mit Fig. 1 erwähnten Durchbrechungen oder "Fenster" 29 befinden sich nun im Bereich der Abkröpfungen (Fig. 5 und 6).

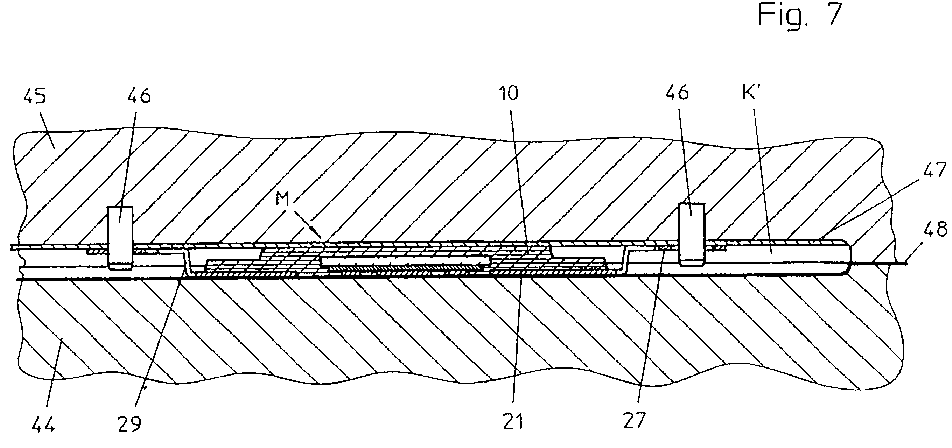

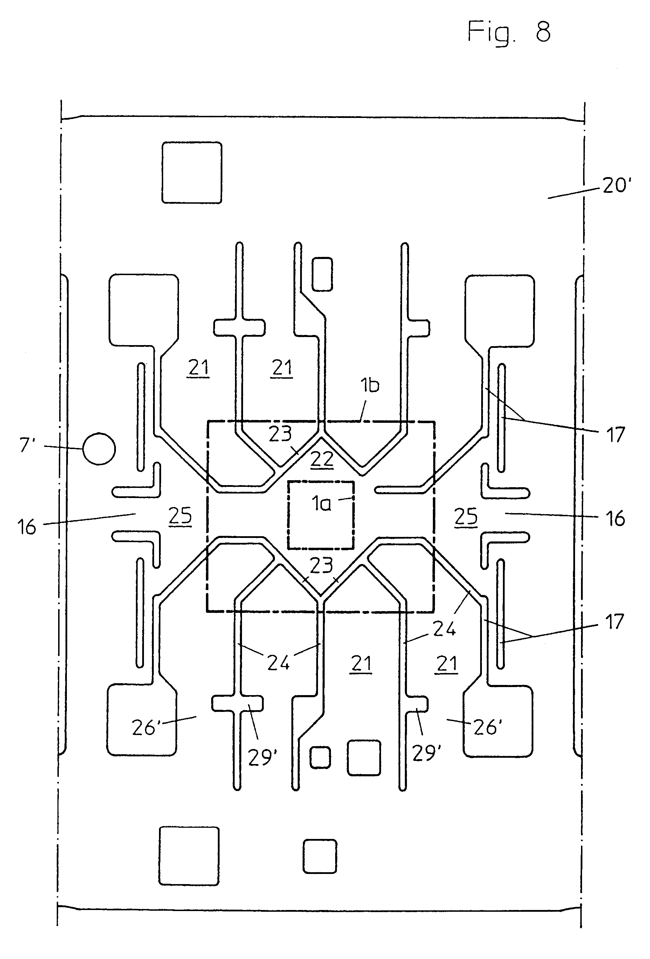

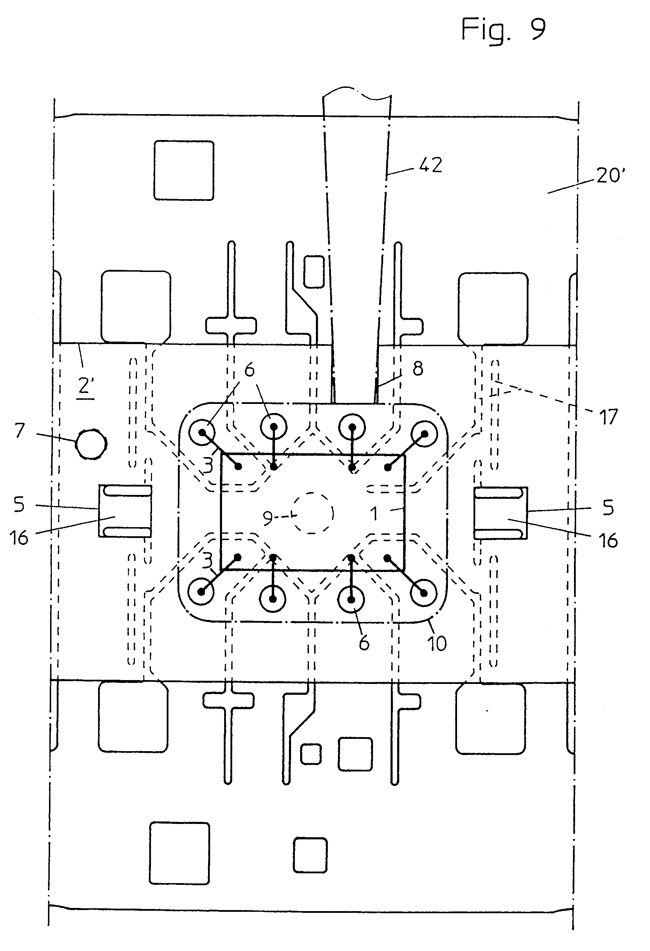

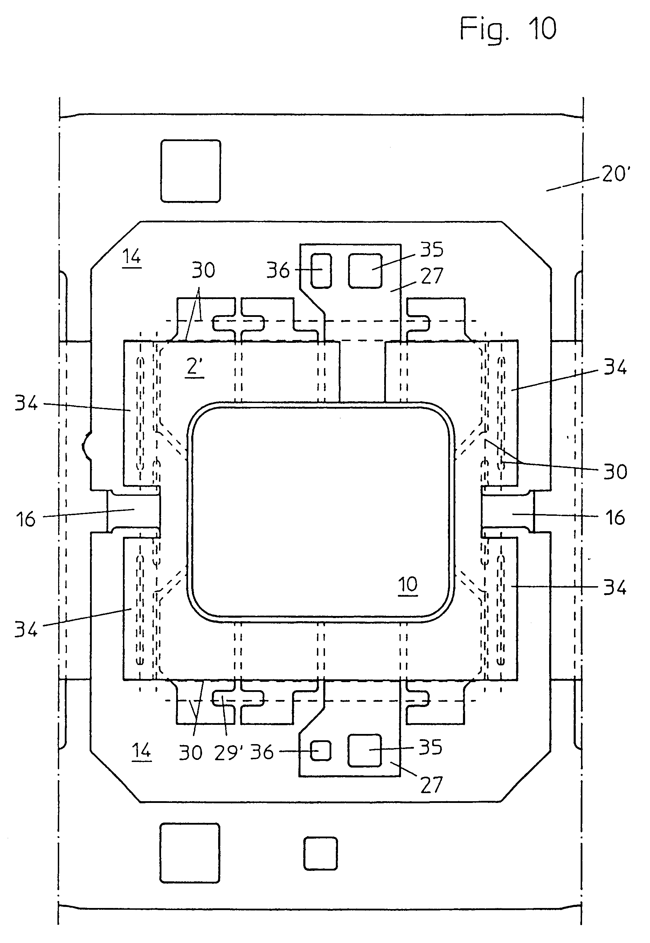

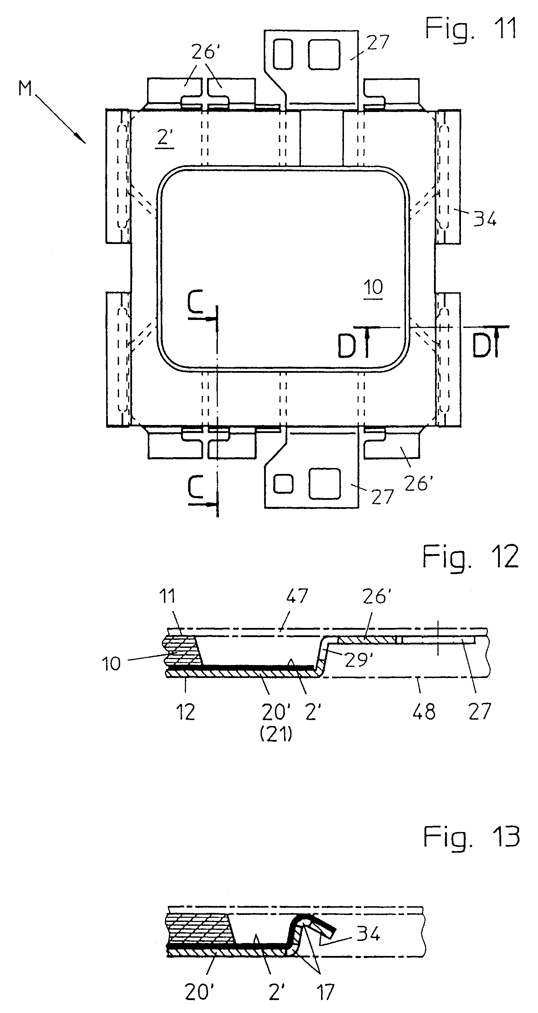

Das fertiggestellte Elektronikmodul M nach Fig. 5 und 6 ist nun bereit, um in eine Spritzgiessform nach Fig. 7 mit den Formhälften 44 und 45 eingelegt zu werden. In den Enden der beiden Fortsätze 27 sind zweckmässigerweise Oeffnungen 35 vorgesehen für den Angriff von Greifern eines Montageroboters. Daneben befinden sich Zentrieröffnungen 36, in die Zentrierstifte 46 der Giessform nach Fig. 7 eingreifen, um das Modul M im Formhohlraum K' für die Chipkarte genau zu positionieren. Es ist hervorzuheben, dass diese Positionierung direkt an den Aussenkontakten des Moduls erfolgt und nicht mittelbar über das Modulgehäuse.

Die ausserhalb des Kunststoffgehäuses 10 liegenden Fortsätze 27 des Systemträgers 20 sind allgemein zum Zusammenwirken mit Montageautomaten beim Handling der Module M bestimmt. Deren (z.B. wie dargestellt ausgebildete) Greifer- und/oder Positionierungs-Konturen 35,36 an der Metallstruktur stehen zu den Aussenkontakten 21 des Moduls in genauer Lagebeziehung. Damit wird ein sicheres automatisches Manipulieren und Positionieren - beispielsweise auch bei Testoperationen, beim Verpacken usw. - gewährleistet. Eine hohe Positioniergenauigkeit ist dabei einerseits durch die Metallstruktur (anstelle des Kunststoffs), aber auch durch den relativ grossen Abstand zwischen den Konturen 35, 36 an den beiden Fortsätzen 27 gegeben.

In die Giessform 44, 45 nach Fig. 7 kann eine dünne Dekorationsfolie 48 eingelegt werden, auf die das Elektronikmodul M mit seiner Flachseite 12 bzw. mit den Aussenkontakten zu liegen kommt. Es handelt sich um eine bedruckte Folie für ein Thermotransfer-Druckverfahren, bei dem das Druckmuster auf der Folie sich nur mit dem in den Formhohlraum K' einzuspritzenden Kunststoff verbindet, nicht aber mit den Metallteilen des Elektronikmoduls. Mit der Folie 48 wird auf an sich bekannte Weise die betreffende Seite der Chipkarte bedruckt. Das Elektronikmodul M ist in der oberen Formhälfte 45 von einer Etikette 47 überdeckt, die sich über das ganze Chipkarten-Format erstreckt und ihrerseits bedruckt ist. Das Einspritzen des die Chipkarte bildenden Kunststoffes (Thermoplast, vorzugsweise ABS) in den Formhohlraum K' erfolgt ebenfalls nach bekannter Technik. Dabei wird das Modul M, mit dem Material der Karte genau fluchtend, an seinen Rändern rings umgossen. Das Thermoplastmaterial tritt dabei durch die "Fenster" 29 wie auch seitlich zwischen sämtlichen Fortsätzen 26, 27 hindurch. Es entsteht dabei eine äusserst stabile mechanische Verankerung der Metallteile des Moduls, insbesondere seiner Aussenkontakte, mit dem Material der Karte. Von Bedeutung ist auch, dass das Modul weder an der einen noch an der anderen Flachseite mit Thermoplast hintergossen wird, d.h. die Dicke des Thermoplastmaterials der Karte ist gleich der Dicke des Elektronikmoduls. Es steht also für das Modulgehäuse 10 die gesamte mögliche Dicke zur Verfügung: Bei der gegebenen Kartendicke von 0,82 mm und einer Dicke der Etikette 47 von z.B. 0,12 mm ergibt sich somit eine Dicke des Modulgehäuses 10 von 0,7 mm.

Das beschriebene Elektronikmodul bzw. geeignete Varianten desselben empfiehlt sich auch zum Eingiessen in andere flache Kunststoff-Gegenstände bzw. Trägerkörper wie z.B. elektronische Schlüssel. Grundsätzlich sind jedoch auch andere Einbau- und Verwendungsarten möglich, wo die Flachbauweise des Moduls verlangt ist oder besondere Vorteile bringt, wie etwa bei Komponenten für Oberflächenmontage (SMD-Technik, surface mounted devices).

## Patentansprüche

1. Elektronikmodul (**M**) in Flachbauweise, mit Aussenkontakten **(21)**, die mit einem Kunststoffgehäuse **(10)** verbunden und aus einem Systemträger **(20)** in Form einer flachen Blechstruktur gebildet sind, und mit einem auf dem Systemträger **(20)** montierten und vom Kunststoffgehäuse **(10)** umgebenen Halbleiter-Chip **(1)**,
**dadurch gekennzeichnet**,
dass der Systemträger **(20)** aus dem Kunststoffgehäuse **(10)** ragende Fortsätze **(27)** aufweist, die mit Greifer- und/oder Positionierungskonturen **(35, 36)** versehen sind, welche zu den Aussenkontakten **(21)** des Elektronikmoduls (**M**) in genauer Lagebeziehung stehen und dazu bestimmt sind, mit Montageautomaten zusammenzuwirken.

2. Elektronikmodul (**M**) nach Patentanspruch 1,
**dadurch gekennzeichnet**,
dass es zwei Fortsätze **(27)** aufweist, die an zwei einander gegenüberliegenden Rändern des Kunststoffgehäuses **(10)** angeordnet sind.

3. Elektronikmodul (**M**) nach Patentanspruch 1,
**dadurch gekennzeichnet**,
dass jeder Fortsatz **(27)** von einem der Aussenkontakte **(21)** ausgeht, ausserhalb des Kunststoffgehäuses **(10)** eine Abkroepfung mit der Höhe des Kunststoffgehäuses **(10)** aufweist und mit seinem Ende in der Ebene einer den Aussenkontakten **(21)** gegenüberliegenden Aussenflaeche **(11)** des Kunststoffgehäuses **(10)** liegt.

4. Chipkarte, insbesondere Kreditkarte, mit einem Kunststoffkörper aus einer Giessmasse, welcher Kunststoffkörper ein Elektronikmodul (**M**) nach Patentanspruch 1 enthält,
**dadurch gekennzeichnet**,
dass die Dicke der Giessmasse gleich der Dicke des Elektronikmoduls (**M**) ist.
